# EUROPEAN PATENT SPECIFICATION

(11) **EP 3 291 652 B1**
(45) Date of publication and mention of the grant of the patent: **31.01.2024**
(21) Application number: 16875976.9
(22) Date of filing: 08.12.2016
(51) Int. Cl.: H05K 1/02, H05K 7/20, H02J 7/02, H02J 7/04, H05K 1/18, H05K 3/24

(54) **PRINTED CIRCUIT BOARD HEAT DISSIPATION SYSTEM USING HIGHLY CONDUCTIVE HEAT DISSIPATION PAD**
WÄRMEABLEITUNGSSYSTEM FÜR LEITERPLATTE MIT HOCHLEITFÄHIGEM WÄRMEABLEITUNGSKISSEN
SYSTÈME DE DISSIPATION THERMIQUE DE CARTE DE CIRCUIT IMPRIMÉ UTILISANT UNE PASTILLE DE DISSIPATION THERMIQUE HAUTEMENT CONDUCTRICE

(30) Priority: 18.12.2015 KR 20150182274
(43) Date of publication of application: 07.03.2018
(73) Proprietor: LG Energy Solution, Ltd., Seoul 07335 (KR)
(72) Inventor: YOON, Seung Kyu, Daejeon 34094 (KR); BANG, Jun Young, Daejeon 34112 (KR)
(74) Representative: Plasseraud IP
(86) International application number: PCT/KR2016/014383
(87) International publication number: WO 2017/105034

(56) References cited:
- EP-A1- 0 974 249
- EP-A1- 1 060 645
- JP-A- 2005 332 840
- KR-A- 20100 109 332
- KR-A- 20120 009 258
- KR-B1- 100 939 760
- KR-B1- 101 434 224
- US-A- 6 062 903
- US-A1- 2011 067 902
- US-A1- 2014 338 964

## Description

### TECHNICAL FIELD

The present disclosure relates to a printed circuit board with a heat-dissipating system using a high conductance heat-dissipating pad, and more particularly, to a printed circuit board with a heat-dissipating system using a high conductance heat-dissipating pad, the system being capable of reducing heat generated on a printed circuit board and efficiently dissipating the generated heat.

### BACKGROUND ART

In general, printed circuit boards, in which connection of components using respective wires in related arts is excluded and electrical paths of circuits are formed by printing conductive patterns on the boards, are indispensably required for integrating circuits and have been widely used recently in all electronic and electrical circuits.

When elements are mounted on a printed circuit board and power is supplied, heat is inevitably generated due to resistive components disturbing the current flow between conductive patterns and elements on the printed circuit board. When heat is generated, a case occurs in which elements, such as a microprocessor, an FET, or a regulator, are sensitive to heat and malfunction due to the heat. In particular, due to active technical development of surface mount devices, a technology has been developed in which a lot of elements are mounted on one printed circuit board, and a phenomenon in which heat generated in any one component affects other components may also occur.

As such, in order to address the problem that heat is generated on a printed circuit board, various techniques have been actively studied also in related arts to dissipate heat, and a separate configuration such as a heat sink or cooler has been used to solve the heat generation problem.

In addition, when a charging/discharging FET is mounted on a printed circuit board, in order to solve the heat generation problem in related arts, a separate heat dissipating plate is installed close to the FET to prevent the FET to be overheated. In this case, due to a limit in the sizes of the charging/discharging FET and the heat dissipating plate, it is difficult to manufacture a battery pack in a small size.

Accordingly, in order to solve the heat generation problem, a technique is required, in which less heat is generated when current flows, the generated heat is dissipated to the outside, and a battery pack may be manufactured in a small size.
US6062903 A relates to an improved interconnect apparatus for high power circuits that is low in cost and amenable for integration with low power circuits in a single electronic package.
US 6 062 903 A relates to a high power surface mount interconnect apparatus for an electric power control unit.
US2014/338964 A1 relates to a power chain on a circuit board.
EP 0 974 249 A1 relates to a process for producing printed circuits.
US 2011/067902 A1 relates to a heat dissipating circuit board.
KR 101 434 224 B1 relates to a battery protection circuit capable of applying a stable voltage and a package of a battery protection circuit module, capable of controlling a precise current.
EP 1 060 645 A1 relates to an electric conductor with a surface structure in the form of flanges and etched grooves.

### DISCLOSURE OF THE INVENTION

It is an object of the present disclosure to provide a printed circuit board with a heat-dissipating system which allows to reduce heat generation and to efficiently dissipate the heat generated on the printed circuit board, and also to provide a printed circuit board with a heat-dissipating system for a battery charging/discharging circuit in which the heat-dissipating system is configured so that a battery pack may be manufactured in a small size.

### TECHNICAL SOLUTION

The invention provides a printed circuit board as defined in claim 1.

In accordance with an exemplary embodiment according to the set of claims, a printed circuit board has electronic components mounted thereon; a conductive pattern providing a current path between the electronic components; and a heat dissipating system comprising a heat-dissipating pad dissipating heat generated due to current flowing through the conductive pattern of the printed circuit board. The heat dissipating pad comprises a body, a heat-dissipating part and lead parts. The heat dissipating part is positioned on the body of the heat dissipating pad and has a comb structure.

The high-conductance heat-dissipating pad includes a lead part formed of a material having an electrical conductivity greater than that of the conductive pattern of the printed circuit board, and the entire or a predetermined section of the lead parts is configured to directly contact the conductive pattern such that the greater part of the current normally flowing through the conductive pattern now flows through the lead parts.

The lead part which contacts the conductive pattern contacts both ends of a predetermined section of the conductive pattern through which current flows.

In accordance with another exemplary embodiment, the electronic components of a printed circuit board constitute a charging/discharging circuit which dissipates heat, comprising a conductive pattern providing a path through which charging/discharging current flows; andcharging/discharging FETs mounted on the printed circuit board.

Both ends or the entire surface of the lead part may contact a predetermined section through which current of the conductive pattern flows, and the lead parts may provide alternative paths such that the current flows in a predetermined section, not through the conductive pattern but through lead parts.

The lead part may include: a first lead part electrically contacting a conductive pattern through which charging current flows; and a second lead part contacting a conductive pattern through which discharging current flows, wherein the first lead part and the second lead part may be formed on one and the other sides of a lower surface of a body of the high-conductance heat dissipating pad at respective positions facing each other

The charging/discharging FETs may have leads formed in right-angle shapes and may be mounted such that the body of the FETs are horizontal to the printed circuit board.

### ADVANTAGEOUS EFFECTS

In accordance with exemplary embodiments, a heat-dissipating system using a high-conductance heat-dissipating pad reduces heat generation of a printed circuit board and dissipates the generated heat to the outside. Thus, heat dissipation may be efficiently performed.

### BRIEF DESCRIPTION OF THE DRAWINGS

FIG. 1 is a top plan view of a printed circuit board with a heat-dissipating system using a high-conductance heat-dissipating pad in accordance with an exemplary embodiment.
FIG. 2 is a front view of a printed circuit board with a heat-dissipating system using a high-conductance heat-dissipating pad in accordance with an exemplary embodiment.
FIG. 3 is a configuration view of a high-conductance heat-dissipating pad.

### MODE FOR CARRYING OUT THE INVENTION

Hereinafter, exemplary embodiments will be described in detail with reference to contents illustrated in accompanying drawings. However, the present disclosure should not be construed as limited to the exemplary embodiments. Rather, these embodiments are provided so that this disclosure will be thorough and complete, and will fully convey the scope of the present invention to those skilled in the art.

### 1. 1. Example of heat-dissipating system for printed circuit board using high-conductance heat-dissipating pad in accordance with an exemplary embodiment

A heat-dissipating system in accordance with an exemplary embodiment is configured such that FETs 310, 320 which switch charging/discharging current to control the charge/discharge of a battery pack are mounted on a printed circuit board 100 to reduce heat generation while the charging/discharging current flows, and a high-conductance heat-dissipating pad 200 which efficiently dissipates the generated heat is mounted on the printed circuit board 100.

Lead parts 231, 232 of the high-conductance heat-dissipating pad 200 electrically contact a predetermined section of a conductive pattern 110a, 110b on the printed circuit board 100.

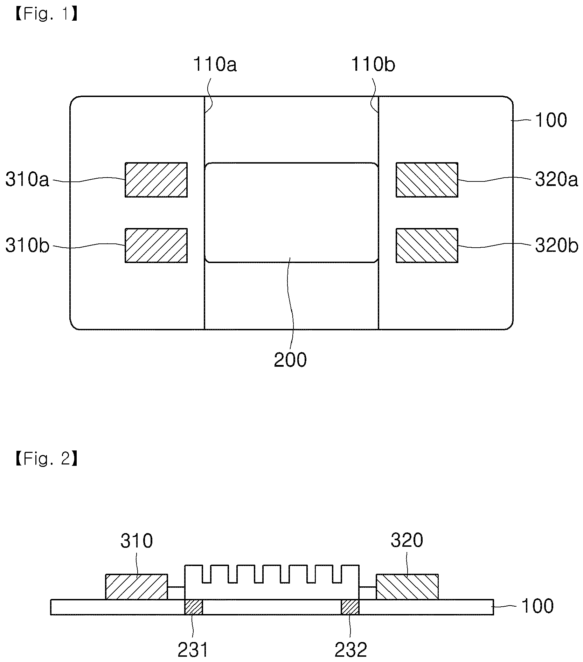

To this end, the present disclosure is configured to include the printed circuit board 100, the high-conductance heat-dissipating pad 200, and the FETs 310, 320.
Hereinafter, with reference to FIGS. 1, 2, and 3, each configuration will be described in detail.

In general, on the printed circuit board 100, an electrical path is formed by printing the conductive pattern 110a, 110b on the board such that current may flow.

When an electronic component is mounted on the printed circuit board 100, current flows through the conductive pattern 110a, 110b, and heat is generated due to resistive components disturbing the current flow.

However, when heat is generated, since the electronic component mounted on the printed circuit board may malfunction, heat generation should be prevented and the generated heat should be dissipated.

The high-conductance heat-dissipating pad 200, which has lead parts 231, 232 formed of a material having an electrical conductivity greater than that of the conductive pattern 110a, 110b, functions to allow current to flow through lead parts 231, 232 having a greater electrical conductivity in a contacted predetermined region after the lead parts 231, 232 are brought into contact with both ends of the predetermined region of the conductive pattern 110a, 110b, and thus allows less heat to be generated than is generated when current flows through the conductive pattern 110a, 110b.

In addition, the heat generated in the lead parts 231, 232 is dissipated to the outside through heat dissipating parts 220.

To this end, the high-conductance heat-dissipating pad 200 is configured to include a body 210, heat-dissipating parts 220, and lead parts 231, 232.

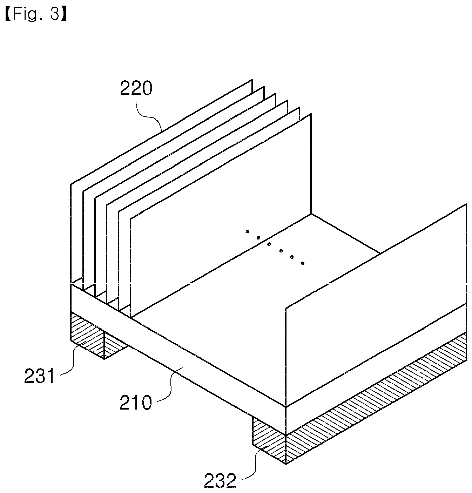

Hereinafter, referring to FIG. 3, more detailed description will be provided.

The body 210 of the high-conductance heat-dissipating pad 200 having a predetermined thickness and area, has the heat-dissipating parts 220 positioned thereon to be in contact therewith and allows lead parts 231, 232 to be in contact therewith and positioned thereon, and functions to connect these to be configured as one heat dissipating pad.

The heat dissipating parts 220, positioned on the body 210, have a comb structure, and function to dissipate heat, which is received from the body 210, to the outside.

The heat dissipating parts 220 function to immediately dissipate the heat generated when current flows through the lead parts 231, 232 and thereby prevent the temperature on the printed circuit board 100 from rising.

The lead parts 231, 232 are positioned under the body 210 and include a first lead part 231 and a second lead part 232.

The lead parts 231, 232 are configured to have a predetermined thickness at an end portion in one direction under the body 210 and a length as long as the length of the body 210 in the one direction, and the first lead part 231 and the second lead part 232 are positioned to face each other on one and the other sides of the end portion of the lower surface of the body 210 in the one direction.

Here, the one direction of the body 210 means a horizontal side or a vertical side of the body 210.

Meanwhile, the lead parts 231, 232 are formed of a material having an electrical conductivity greater than that of the conductive pattern 110a, 110b and electrically contact the conductive pattern 110a, 110b.

When the lead parts 231, 232 contact the conductive pattern 110a, 110b, both ends or the entire surface of the lead parts 231, 232 contact both ends of a predetermined section of the conductive pattern 110a, 110b.

When the lead parts 231, 232 contact the conductive pattern 110a, 110b, since the electrical conductivity of the lead parts 231, 232 is greater than that of the conductive pattern 110a, 110b, the current having flown through the conductive pattern 110a, 110b flows through the lead parts 231, 232 from both ends of the predetermined contact section.

The lead parts 231, 232 provide an alternative path through which charging/discharging current may pass, and thereby allow less heat to be generated than is generated when charge/discharge current flows through the conductive pattern 110a, 110b. In accordance with an exemplary embodiment, the first lead part 231 provides an alternative path which electrically contacts the conductive pattern, through which charging current flows, and provides an alternative path through which the charging current may flow, and the second lead part 232 provides an alternative path which electrically contacts the conductive pattern, through which discharging current flows, and provides an alternative path through which the discharging current may flow.

The FETs 310, 320are mounted on the printed circuit board 100, function to switch charging/discharging current when charging/discharging a battery, and include a charging FET 310 for switching charging current and a discharging FET 320 for switching discharging current.

The FETs 310, 320 in accordance with the present disclosure have a lead formed in a right angle and are mounted such that the bodies of the FETs 310, 320 are parallel to the printed circuit board 100.

Through this, in comparison with mounting the body of the FET 310, 320 to be erected upright on the printed circuit board 100, the mounting height may be reduced, and thus, a battery pack may be manufactured in a small size.

## Claims

1. A printed circuit board (100) having
electronic components mounted thereon, a conductive pattern (110a, 110b) providing a current path between the electronic components; and
a heat dissipating system comprising
a heat-dissipating pad (200) dissipating heat generated due to current flowing through the conductive pattern (110a, 110b) of the printed circuit board (100), said heat-dissipating pad comprising a body (210), a heat-dissipating part (220) and lead parts (231, 232),
wherein the heat-dissipating part (220) is positioned on the body (210) and has a comb structure,
**characterized in that**
the lead parts (231, 232) are formed of a material having a greater electrical conductivity than the conductive pattern (110a, 110b) of the printed circuit board (100), and
an entire or a predetermined section of the lead parts (231, 232) is configured to directly contact the conductive pattern (110a, 110b) such that the greater part of the current normally flowing through the conductive pattern (110a, 110b) now flows through the lead parts (231, 232),
wherein the lead parts (231, 232) which contact the conductive pattern (110a, 110b) contact both ends of a predetermined section of the conductive pattern (110a, 110b) through which current flows.

2. The printed circuit board (100) according to claim 1, constituting a battery charging/discharging circuit which dissipates heat, comprising:
a conductive pattern (110a, 110b) providing a path through which charging/discharging current flows; and
charging/discharging FETs (310, 320) mounted on the printed circuit board (100).

3. The printed circuit board (100) of claim 2, wherein
both ends or the entire surface of the lead parts (231, 232) contacts predetermined sections through which current of the conductive pattern (110a, 110b) flows and
the lead parts (231, 232) provide alternative paths such that the current flows in a predetermined section, not through the conductive pattern (110a, 110b), but through lead parts (231, 232).

4. The printed circuit board (100) of claim 2, wherein the lead parts (231, 232) comprise:
a first lead part (231) electrically contacting a conductive pattern (110a) through which charging current flows; and
a second lead part (232) contacting a conductive pattern (110b) through which discharging current flows, wherein
the first lead part (231) and the second lead part (232) are formed on one and the other sides of a lower surface of the body (210) of the high-conductance heat dissipating pad (200) at respective positions facing each other.

5. The printed circuit board (100) of claim 2, wherein the charging/discharging FETs (310, 320) have leads formed in right-angle shapes and are mounted such that the bodies of the FETs (310, 320) are parallel to the printed circuit board (100).

## Patentansprüche

1. Gedruckte Schaltplatine (100), aufweisend:
daran montierte elektronische Komponenten, ein leitfähiges Muster (110a, 110b),
welches einen Strompfad zwischen den elektronischen Komponenten bereitstellt; und
ein Wärme-Verteilungssystem, umfassend
ein wärmeverteilendes Kissen (200), welches Wärme verteilt, welche aufgrund eines Stroms erzeugt wird, welcher durch das leitfähige Muster (110a, 110b) der gedruckten Schaltplatine (100) fließt, wobei das wärmeverteilende Kissen einen Körper (210), einen wärmeverteilenden Teil (220) und Leitungsteile (231, 232) umfasst,
wobei der wärmeverteilende Teil (220) an dem Körper (210) positioniert ist und eine Kammstruktur aufweist,
**dadurch gekennzeichnet, dass**
die Leitungsteile (231, 232) aus einem Material mit einer größeren elektrischen Leitfähigkeit als das leitfähige Muster (110a, 110b) der gedruckten Schaltplatine (100) gebildet sind, und
ein vollständiger oder ein vorbestimmter Abschnitt der Leitungsteile (231, 232) dazu eingerichtet ist, direkt das leitfähige Muster (110a, 110b) derart zu kontaktieren, dass der größere Teil des Stroms, welcher normalerweise durch das leitfähige Muster (110a, 110b) fließt, nun durch die Leitungsteile (231, 232) fließt,
wobei die Leitungsteile (231, 232), welche das leitfähige Muster (110a, 110b) kontaktieren, beide Enden eines vorbestimmten Abschnitts des leitfähigen Musters (110a, 110b) kontaktieren, durch welches Strom fließt.

2. Gedruckte (100) nach Anspruch 1, welches eine Batterie-Lade/Entladeschaltung bildet, welche Wärme verteilt, umfassend:
ein leitfähiges Muster (110a, 110b), welches einen Pfad bereitstellt, durch welchen Lade/Entladestrom fließt; und
Lade/Entlade-FETs (310, 320), welche an der gedruckten Schaltplatine (100) montiert sind.

3. Gedruckte Schaltplatine (100) nach Anspruch 2, wobei
beide Enden oder die gesamte Fläche der Leitungsteile (231, 232) vorbestimmte Abschnitte kontaktiert, durch welche Strom des leitfähigen Musters (110a, 110b) fließt, und
die Leitungsteile (231, 232) alternative Pfade bereitstellen, so dass der Strom in einem vorbestimmten Abschnitt fließt, nicht durch das leitfähige Muster (110a, 110b) sondern durch Leitungsteile (231, 232).

4. Gedruckte Schaltplatine (100) nach Anspruch 2, wobei die Leitungsteile (231, 232) umfassen:
einen ersten Leitungsteil (231), welcher elektrisch ein leitfähiges Muster (110a) kontaktiert, durch welches Ladestrom fließt; und
einen zweiten Leitungsteil (232), welcher ein leitfähiges Muster (110b) kontaktiert, durch welches Entladestrom fließt, wobei
der erste Leitungsteil (231) und der zweite Leitungsteil (232) an einer und der anderen Seite einer unteren Fläche des Körpers (210) des wärmeverteilenden Kissens (200) mit hoher Leitfähigkeit an jeweiligen zueinander weisenden Positionen gebildet sind.

5. Gedruckte Schaltplatine (100) nach Anspruch 2, wobei die Lade/Entlade-FETs (310, 320) Leitungen aufweisen, welche in rechtwinkligen Formen gebildet sind und derart montiert sind, dass die Körper der FETs (310, 320) parallel zu der gedruckten Schaltplatine (100) sind.

## Revendications

1. Carte de circuit imprimé (100) ayant
des composants électroniques montés sur celle-ci, une impression conductrice (110a, 110b) fournissant un trajet de courant entre les composants électroniques ; et
un système de dissipation thermique comprenant
une pastille de dissipation thermique (200) dissipant la chaleur générée en raison du courant circulant à travers l'impression conductrice (110a, 110b) de la carte de circuit imprimé (100), ladite pastille de dissipation thermique comprenant un corps (210), une partie de dissipation thermique (220) et des parties de connexion (231, 232),
dans laquelle la partie de dissipation thermique (220) est positionnée sur le corps (210) et a une structure en peigne,
**caractérisée en ce que**
les parties de connexion (231, 232) sont constituées d'un matériau ayant une plus grande conductivité électrique que l'impression conductrice (110a, 110b) de la carte de circuit imprimé (100), et
une totalité ou une sélection prédéterminée des parties de connexion (231, 232) est configurée pour être en contact direct avec l'impression conductrice (110a, 110b) de sorte que la plus grande partie du courant circulant normalement à travers l'impression conductrice (110a, 110b) circule maintenant à travers les parties de connexion (231, 232),
dans laquelle les parties de connexion (231, 232) qui sont en contact avec l'impression conductrice (110a, 110b) sont en contact avec les deux extrémités d'une section prédéterminée de l'impression conductrice (110a, 110b) à travers laquelle le courant circule.

2. Carte de circuit imprimé (100) selon la revendication 1, constituant un circuit de charge/décharge de batterie qui dissipe la chaleur, comprenant :
une impression conductrice (110a, 110b) fournissant un trajet à travers lequel le courant de charge/décharge circule ; et
des FET (310, 320) de charge/décharge montés sur la carte de circuit imprimé (100).

3. Carte de circuit imprimé (100) selon la revendication 2, dans laquelle
les deux extrémités ou la surface totale des parties de connexion (231, 232) sont en contact avec des sections prédéterminées à travers lesquelles le courant de l'impression conductrice (110a, 110b) circule et
les parties de connexion (231, 232) fournissent des trajets de remplacement de sorte que le courant circule dans une section prédéterminée, non pas à travers l'impression conductrice (110a, 110b), mais à travers des parties de connexion (231, 232).

4. Carte de circuit imprimé (100) selon la revendication 2, dans laquelle les parties de connexion (231, 232) comprennent :
une première partie de connexion (231) en contact électrique avec une impression conductrice (110a) à travers laquelle le courant de charge circule ; et
une seconde partie de connexion (232) en contact avec une impression conductrice (110b) à travers laquelle le courant de décharge circule, dans laquelle
la première partie de connexion (231) et la seconde partie de connexion (232) sont formées sur l'un et l'autre côtés d'une surface inférieure du corps (210) de la pastille de dissipation thermique (200) à grande conductance à des positions respectives se faisant face.

5. Carte de circuit imprimé (100) selon la revendication 2, dans laquelle les FET (310, 320) de charge/décharge ont des connexions présentant des formes à angle droit et sont montés de sorte que les corps des FET (310, 320) soient parallèles à la carte de circuit imprimé (100).
